# FASCICULE DE BREVET EUROPEEN

(11) **EP 1 244 523 B1**
(45) Date de publication et mention de la délivrance du brevet: **04.06.2003**
(21) Numéro de dépôt: 00993696.4
(22) Date de dépôt: 13.12.2000
(51) Int. Cl.: B05C 5/02, B05D 3/04, B05D 7/22, B65B 31/02

(54) **DISPOSITIF DE REMPLISSAGE COLLECTIF DE CAVITES BORGNES**
VORRICHTUNG ZUM GEMEINSAMEN FÜLLEN VON BLINDEN HOHLRÄUMEN
DEVICE FOR COLLECTIVELY FILLING BLIND CAVITIES

(30) Priorité: 03.01.2000 FR 0000008; 26.07.2000 FR 0009785
(43) Date de publication de la demande: 02.10.2002
(73) Titulaire: Societe Novatec S.A., 82000 Montauban (FR)
(72) Inventeur: Bourrieres, Francis, 82000 Montauban (FR); Kaiser, Clément, 82000 Montauban (FR)
(86) Numéro de dépôt international: FR0003494
(87) Numéro de publication internationale: WO01049422

(56) Documents cités:
- WO-A-97/48500
- WO-A-99/47260

## Description

Le dispositif objet de la présente invention a pour fonction le remplissage de cavités borgnes par des produits visqueux. Le remplissage de cavités borgnes par un produit visqueux est rendu difficile par le fait que l'air ou le gaz présent dans la cavité ainsi que la viscosité ou les tensions superficielles du produit s'opposent au bon remplissage de cavités de faibles dimensions ou de cavités qui présentent des étranglements. En effet, des dispositifs de transfert de produit à travers un masque ont été décrits dans l'art antérieur comme par exemple dans les brevets FR2765813 et W098/16387 du même inventeur. Ces dispositifs permettent un remplissage d'ouvertures présentes dans un masque, ce dernier, généralement composé d'un clinquant métallique, étant posé ou poussé contre le substrat sur lequel le dépôt doit être réalisé. Afin que le remplissage de l'ouverture du masque puisse avoir lieu, il faut que l'air puisse s'échapper entre le masque et le substrat, ce qui est le cas dans la plupart des applications car l'étanchéité entre le masque et le substrat n'est pas parfaite. Dans la présente invention, il s'agit de remplir des cavités borgnes dans lesquelles l'air n'a pas d'échappatoire.

Les domaines d'applications de la présente invention sont multiples, à titre d'exemple non limitatif, elle est applicable dans les domaines tels que l'électronique, le médical, les vias de connexion de puces pour cartes à puces,... Elle est particulièrement adaptée au remplissage de micro-cavités dans le domaine spatial et militaire. Elle pourrait également être utilisée pour la réalisation de composants optiques ou optoélectronique. Le brevet US5,271,801 décrit la réalisation de circuit intégré optique sur un substrat. Pour ce faire, il est évoqué à plusieurs reprises, la nécessité de procéder à une opération de remplissage de cavités avec un produit ayant un index de réfraction connu. Par contre, aucun moyen, aucune méthode n'est proposée pour réaliser ce remplissage. La présente invention vise précisément à proposer un moyen pour atteindre cet objectif

La présente demande de brevet est présentée en continuation de la demande de brevet FR00.00008 déposée le 03/01/2000 par le même demandeur et dont la priorité interne est revendiquée.

Afin d'éviter que l'air présent dans la cavité constitue un obstacle au bon remplissage par le produit, une technique consiste à réaliser cette opération sous vide. Dans ce cas en général, on dispose les cavités à remplir dans une enceinte fermée dans laquelle un vide est appliqué, puis le produit est forcé dans les cavités par le biais d'une seringue ou d'un dispenseur. Cette technique bien que fonctionnelle présente un certain nombre d'inconvénients, comme par exemple :
- l'enceinte sous vide doit être suffisamment grande pour recevoir le système d'injection, ce qui impose de dimensionner la pompe à vide en conséquence.
- De plus, il faut traiter tous les problèmes d'étanchéités entre l'intérieur et l'extérieur de la chambre sous vide. Ceci impose un certain nombre de difficultés d'accessibilité, de rechargement du dispositif en produit et par conséquent de coût de réalisation de ce genre d'équipement.
- Enfin ce type d'équipement se prête mal à la production en série de type défilement car il faut prévoir des sas d'entrée et de sortie entre l'intérieur et l'extérieur de la chambre sous vide ou alors prévoir un avancement pas à pas et refaire le vide à chaque pas. Dans tous les cas, ce type d'équipement devient extrêmement complexe et onéreux.
- D'autre part, pour faire passer un produit visqueux dans des cavités de faible dimension ou présentant des étranglements, il faut injecter le produit sous pression au niveau des orifices pour le forcer au remplissage.

D'autres techniques ont été développées en vue de faire des dépôts de produits à l'intérieur de tubes de faible diamètre ou de pièces plus ou moins poreuses. Ces techniques décrites dans les brevets WO9748500A et WO9947260A consistent à alimenter le produit d'un côté de la pièce à traiter et d'appliquer le vide d'un autre côté, de sorte à aspirer le produit à travers la pièce. Ces techniques ne s'appliquent pas au remplissage de cavités borgnes et ne sont donc pas transposables au cas présent.

Les brevets US5,565,033et US5,478,700 font état de plusieurs dispositifs de remplissage. Sur un des dispositifs montré par exemple en figure 9 et 12 de US5,478,700, il est fait état d'un évent destiné à évacuer l'air ou les particules présentes dans les cavités à remplir. Comme on peut le voir pendant que le produit est injecté, l'air prisonnier dans la cavité est expulsé voire aspiré. Ce dispositif, bien que séduisant présente plusieurs inconvénients. Tout d'abord, suivant la viscosité du produit et de la forme de la cavité, il n'est pas certain d'extraire en totalité l'air avant que le produit n'atteigne l'évent, ce qui se traduira par un remplissage incomplet. De plus, comme on cherche à remplir les cavités en même temps que l'on évacue l'air, du produit vient en contact avec l'évent et conduit à la boucher, ce qui annule son action. La présente invention vise à obvier aux inconvénients cités ci-dessus.

La présente invention propose une solution efficace et simple à mettre en oeuvre. Elle consiste à assurer le vide et le remplissage en série et d'une façon continue strictement au niveau des cavités à remplir avec un léger déphasage dans le temps. Elle se caractérise essentiellement en ce qu'elle consiste à juxtaposer deux fentes sur une surface. La première fente est reliée à un générateur de vide, alors que la deuxième est reliée à un réservoir contenant le produit. La première fente reliée au vide est espacée de façon étanche à la fois de l'extérieur et de la deuxième fente d'une distance, mesurée parallèlement au déplacement du dispositif, supérieure à la dimension du plus grand orifice des cavités à remplir et une étanchéité parfaite est réalisée entre la surface présentant les deux fentes et la face supérieure du substrat présentant les cavités à remplir. Lorsqu'un mouvement relatif du dispositif par rapport au substrat est imprimé, les orifices des cavités sont successivement :
- isolés de façon étanche par rapport à l'extérieur du dispositif,
- exposés à la fente reliée au vide, ce qui a pour effet de réaliser un vide dans les cavités,
- mis en contact avec la fente contenant le produit de remplissage. Or comme le produit est à la pression atmosphérique, voire en surpression lorsqu'il rencontre l'orifice, celui-ci est aspiré par la cavité jusqu'à ce que la pression dans la cavité soit égale à celle dans le réservoir de produit. Evidement si le vide est suffisant, la totalité de la cavité sera remplie par du produit.
Ce dispositif est donc extrêmement intéressant si l'on souhaite remplir des cavités en évitant la présence de bulles d'air.

De façon avantageuse, si les orifices des cavités ne se situent pas dans un plan qui permet de réaliser l'étanchéité avec la surface de contact du dispositif ou encore si l'on veut éviter de faire entrer le produit en contact avec la surface du substrat, il est envisageable d'intercaler un masque intermédiaire entre le dispositif et le substrat à remplir. Le masque peut être réalisé par une feuille métallique ou synthétique qui sera plaquée en contact intime et étanche avec le substrat. Il est également envisageable d'utiliser un masque, temporaire ou non, réaliser à partir d'un film photoimageable laminé ou collé sur le substrat.
De la même façon en intercalant un masque entre le dispositif et le substrat, il est envisageable de faire une opération de sérigraphie. Dans ce cas, la cavité borgne est réalisée par l'ouverture du masque et le substrat et lorsque après passage du dispositif, le masque est séparé du substrat, il restera un dépôt de produit en surépaisseur sur le dit substrat. La présente invention peut donc avantageusement être adaptée sur une machine de sérigraphie et dans ce cas, afin que le système puisse fonctionner dans les deux sens, il est envisageable de placer une troisième fente identique à la première et placée à l'opposé par rapport à la deuxième et dans ce cas on appliquera alternativement le vide dans la première ou la troisième fente en fonction du sens de déplacement du dispositif. Selon des modes particuliers de réalisation :

Pour assurer une meilleure étanchéité au niveau de la fente reliée au réservoir, il est avantageux d'adjoindre des lames de raclage à l'avant et à l'arrière de la fente de distribution. Ces lames de raclage pourront par exemple être réalisées à partir d'une seule lame recourbée et percée de sorte que les deux extrémités se trouvent à l'avant et à l'arrière de la fente de distribution et que les perçages permettent le passage du produit. Une force d'appui peut être exercée pour appuyer les lames en contact avec la surface à racler,

Pour assurer une meilleure étanchéité entre le corps et la surface de raclage présentant les orifices des cavités, il est envisageable d'équiper la partie inférieure du corps avec un corps déformable comme du polyuréthane, qui va se conformer aux irrégularités de surface et empêcher ainsi toute fuite. Naturellement, des joints d'étanchéité disposés au niveau de la face active du corps du dispositif objet de l'invention peuvent assurer le même rôle.

Pour racler proprement un excès de produit, il est également envisageable de disposer une lame de raclage en guise de paroi arrière du dispositif, qui présente un angle mesuré côté produit avec le substrat supérieur à 90°.

Pour accélérer la vitesse de remplissage des cavités par le produit, il est avantageux d'appliquer une surpression sur le produit présent dans le réservoir. D'autres caractéristiques et avantages de l'invention apparaîtront dans la description des dessins joints qui illustrent l'invention.

La figure 1 représente en coupe un dispositif selon l'invention.

La figure 2 représente une vue de dessous du dispositif selon l'invention.

La figure 3A représente en coupe une variante du dispositif selon l'invention appliquée au remplissage d'un pochoir conventionnel sur une machine de sérigraphie.

La figure 3B représente en coupe le dispositif remplissant les cavités aménagées sur un substrat sur lequel est apposé un pochoir mince intermédiaire de propreté.

La figure 4 représente en coupe une autre variante du dispositif selon l'invention.

La figure 5 représente une vue en coupe du dispositif appliqué au remplissage de tubes identiques ou différents positionnés sur un support commun.

La figure 6 représente une vue de dessus du dispositif selon l'invention montée sur une machine à sérigraphier en lieu et place d'une racle.

La figure 7 représente une utilisation du procédé pour l'encapsulage de puces électroniques.

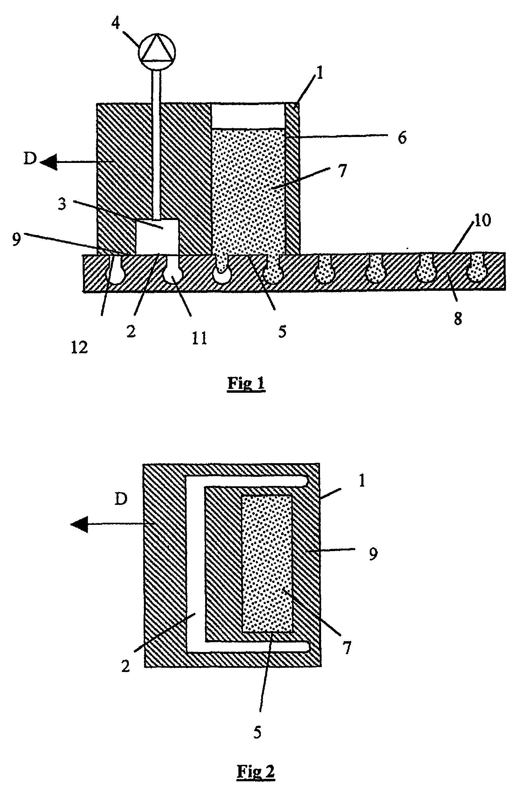

En référence à ces dessins, on peut voir en figure 1 le corps (1) comportant une première fente de dépression (2) reliée à une chambre à vide (3) qui elle-même est reliée à un générateur de vide (4) de tout type connu. Une deuxième fente (5) dite de distribution est reliée à un réservoir (6) contenant le produit (7). Le corps (1) peut être mis en mouvement relatif par rapport au substrat (8) selon le sens (D) tout en maintenant un contact étanche entre la face (9) du corps (1) par rapport à la face (10) du substrat (8) comprenant les cavités (11) à remplir. Lors du mouvement relatif dans le sens (D) du dispositif (1), les orifices (12) des cavités (il) à remplir sont successivement :
- isolés de façon étanche par rapport à l'extérieur du dispositif,
- exposés à la fente reliée au vide,
- mis en contact avec la fente reliée au réservoir contenant le produit de remplissage..
En effet comme la première fente est espacée de façon étanche à la fois de l'extérieur et de la deuxième fente d'une distance, mesurée parallèlement au sens de déplacement du dispositif (1), supérieure au plus grand orifice présent sur le substrat (8) chaque cavité est donc successivement soumise au vide en contact de la fente de dépression (2), sans que cette même cavité puisse être simultanément en contact soit avec l'extérieur du dispositif soit avec la deuxième fente (5), puis à la phase de remplissage par aspiration de produit (7) au contact de la fente de distribution (5). Comme les faces (9) et (10) sont en contact étanche, le vide appliqué dans la cavité au contact de la fente (12), est maintenu jusqu'à ce que le produit soit en contact avec cette même cavité, le produit étant à une pression supérieure que celle régnant dans la cavité, il y est donc aspiré jusqu'à ce que la pression y soit égale à la pression régnant dans le réservoir de produit. Si le vide est suffisamment poussé et si le produit présent dans le réservoir ne présente pas de bulles d'air, ce dispositif permet de remplir des cavités de façon complète et homogène quel que soit le produit visqueux.

En figure 2 est représentée la face (9) du corps (1). La fente de dépression (2) entoure ici la fente de distribution (5) sur trois côtés ainsi le maintien du vide entre les deux fentes est parfaitement assuré et permet donc un remplissage optimum. Cette disposition est particulièrement adaptée car elle permet également un plaquage optimum entre les faces (9) et (10) grâce à la dépression régnant dans la fente (2) et ainsi le contact étanche entre les deux faces est assuré. Il est possible pour encore améliorer le contact étanche d'adjoindre des joints sur la face (9) ou alors de réaliser la partie inférieure du corps (1) en matériau déformable comme du polyuréthane par exemple.

La figure 3A représente un autre mode d'utilisation du dispositif selon l'invention appliquée à une sérigraphie classique. Dans ce cas, les trous borgnes sont formés par la surface supérieure du substrat qui est en contact avec le pochoir (13), dans lequel les ouvertures (14) forment la cavité à remplir.

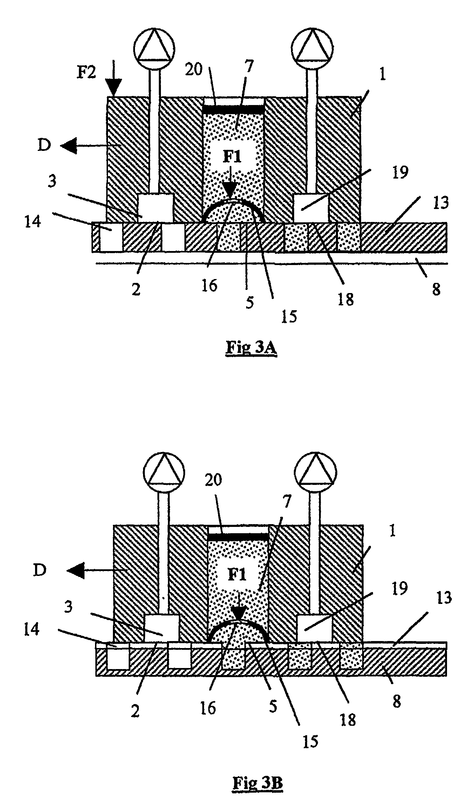

La figure 3B représente un autre mode d'utilisation où la face supérieure du substrat ne doit pas entrer en contact avec le produit ou que la surface du substrat ne permet pas au dispositif selon l'invention de glisser de façon étanche. Dans ce cas, il peut être judicieux de disposer un masque (13) très mince entre le substrat (8) et le corps (1), ainsi les cavités sont réalisées partiellement par les ouvertures (14) pratiquées dans le masque (13), le fond des cavités étant toujours réalisé par le substrat. Pour améliorer le raclage du surplus de produit et éviter toute fuite, il apparaît qu'une lame de raclage (15) par exemple en acier inoxydable disposée à l'arrière de la fente de distribution (5) s'avère particulièrement efficace. Avantageusement cette lame de raclage peut être réalisée par une lame ressort recourbée dans laquelle on a pratiqué des ouvertures (16) pour permettre le passage du produit. Une force (F1), appliquée par un dispositif non représenté, permet d'obtenir une étanchéité parfaite et évite la création d'une fine pellicule de produit à la surface du masque (13) ou du substrat (8).

Ce dispositif selon l'invention peut avantageusement être utilisé pour une opération de sérigraphie, et dans ce cas, il peut être nécessaire de pouvoir fonctionner de façon alternative dans les deux sens. Pour cela, il suffit d'adjoindre une troisième fente (18) identique à (2), symétriquement par rapport à (5) et reliée à une chambre à vide (19). Dans ce cas, lors d'un déplacement en sens opposé à D, on applique le vide dans (19) en gardant (3) à la pression atmosphérique et inversement pour un déplacement dans le sens de D. Afin d'assurer une étanchéité parfaite entre le masque et le substrat ainsi qu'entre la face (9) et le masque, il peut être judicieusement appliqué une force (F2) sur le corps (1) pour plaquer les différentes surfaces les unes contre les autres.

Pour améliorer la vitesse et la qualité de remplissage, il peut être envisagé de mettre le produit (7) sous pression par exemple à l'aide d'un piston (20).

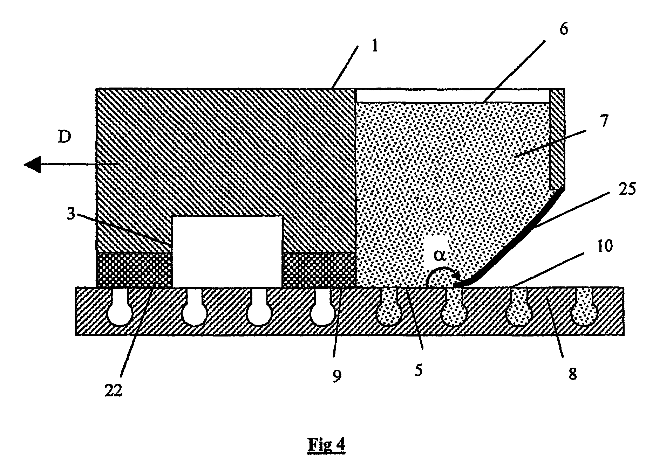

La figure 4 représente en coupe un autre mode de réalisation de la présente invention. Dans ce cas, le corps (1) présente dans sa partie en contact avec le substrat (8), une partie (22) déformable pour se conformer aux irrégularités de la surface (10) ou du masque (13) s'il en est fait usage, sans nuire à la parfaite étanchéité de contact avec la surface (9). Le raclage du surplus de produit est assuré dans ce cas par une lame élastique (25) fixée sur la partie arrière de (1) par un moyen non représenté et qui présente un angle ∝ supérieur ou égal à 90 degrés.

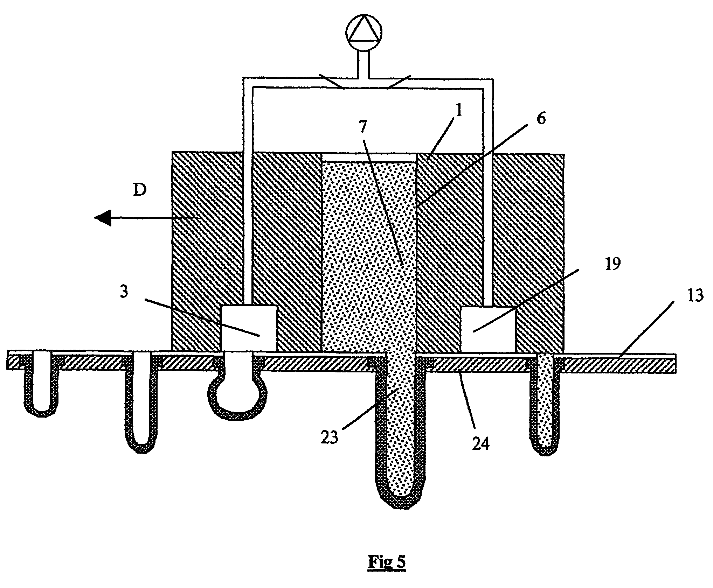

La figure 5 représente en coupe une autre forme possible d'application. Dans ce cas, le but est de remplir collectivement des tubes (23) identiques ou différents. Les tubes (23) sont positionnés sur une plaque support (24). Chaque tube est en appui parfait sur la plaque de façon à éviter toute fuite. Un pochoir d'étanchéité et de propreté très mince (13) avec des ouvertures ménagées en lieu et place des tubes à remplir est positionné au dessus de ces derniers. Le dispositif (1) selon l'invention se déplace à la surface et permet de remplir les tubes (23) par le produit.

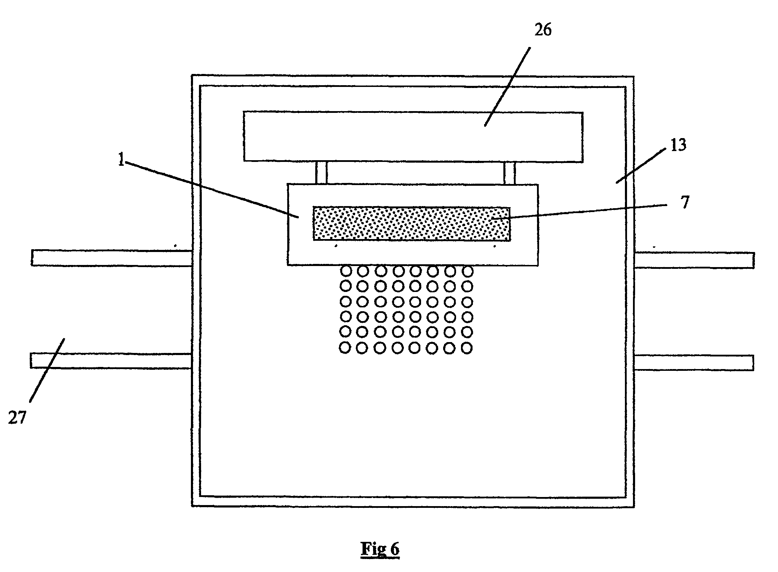

La figure 6 montre comment le dispositif (1), objet de la présente invention, peut être adapté en lieu et place de la racle (26) sur une machine de sérigraphie. Les substrats (8) sont amenés par le convoyeur (27) et la sérigraphie est effectuée à travers le masque (13).

Le dispositif selon la présente invention permet donc comme cela a été dit précédemment de remplir totalement et parfaitement des cavités borgnes. Mais il permet également de faire des remplissages partiels ou des bouchages de cavités borgnes en ajustant la valeur de la dépression dans les chambres à vide (3) ou (19). En effet la valeur du différentiel de pression entre le réservoir de produit et les chambres à vide conditionne la quantité de produit qui va être aspiré dans la cavité.

Le dispositif selon l'invention permet d'accéder à des applications nouvelles dans le domaine de l'interconnexion et de la mise en boîtier appelé aussi packaging ou encapsulage pour des applications électroniques.

Selon l'invention, il est possible d'utiliser le dispositif pour remplir des trous métallisés d'un circuit imprimé, appelés aussi traversées, avec une résine isolante durcissable et usinable. Les dits trous sont préalablement rendus borgnes par un moyen quelconque durant le temps de remplissage. Il est ensuite pratiqué un nouveau perçage dans la résine isolante dont le diamètre est inférieur au premier trou et ce nouveau trou est métallisé en connexion avec les faces supérieures et/ou inférieures. Ainsi, il est rendu possible de réaliser des trous métallisés concentriques multicouches. L'opération peut être répétée pour un nombre de couches supérieur à 2, si ceci est souhaité.

Selon l'invention, il est possible d'utiliser ce procédé pour la réalisation d'encapsulage de puces électroniques sur un substrat par un matériau isolant et durcissable. Pour réaliser cette opération, il est fait usage d'un masque dont les ouvertures constituent un moule et dont les parois sont à dépouille négative de façon à ne pas entraîner de produit lors du démoulage. Malgré cette dépouille négative, il est possible de remplir totalement le volume délimité par le masque grâce à l'utilisation du dispositif.

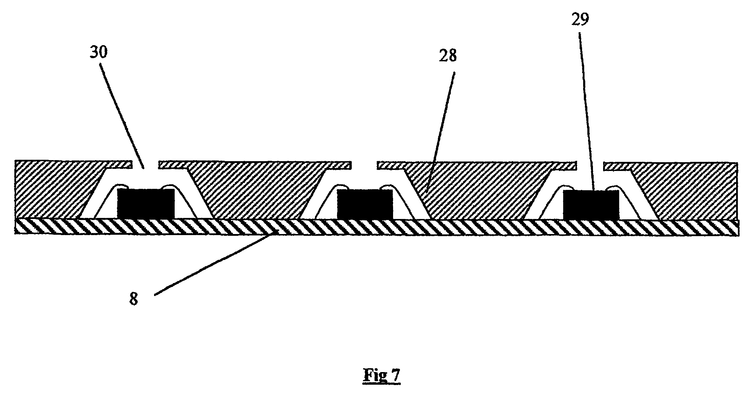

La figure 7 montre le principe de cette application et notamment la forme d'un exemple de masque (28) recouvrant la puce (29) et le trou (30) dans lequel passera le produit.

## Revendications

1. Dispositif de remplissage collectif de cavités borgnes par un produit visqueux (7), comportant un corps (1) mobile en translation sur la surface comprenant les orifices et présentant au moins deux fentes, dont la première à rencontrer les orifices lors du mouvement est reliée à une chambre à vide (3) et la deuxième à rencontrer les orifices est reliée à un réservoir (6) contenant le produit (7) à transférer **caractérisé en ce que** le corps (1) est en contact étanche par rapport à la surface comprenant les orifices des dites cavités, et que la première fente (2) soit espacée de façon étanche à la fois de l'extérieur du dispositif et de la deuxième fente (5) d'une distance, mesurée parallèlement au déplacement du dispositif, supérieure à la dimension du plus grand orifice.

2. Dispositif de remplissage de cavités borgnes par un produit visqueux selon la revendication 1, **caractérisé en ce qu'**une troisième fente (18) identique à la première (2) et disposée symétriquement par rapport à la deuxième (5), permette de faire fonctionner le dispositif dans les deux sens de façon alternative.

3. Dispositif de remplissage collectif de cavités borgnes par un produit visqueux selon les revendications 1 et 2, **caractérisé en ce que** la partie inférieure du corps (1) soit déformable pour admettre des irrégularités de la surface (10).

4. Procédé de remplissage collectif de cavités borgnes (11) par un produit visqueux (7) pour lequel un corps (1) , présentant au moins deux fentes, est déplacé sur la surface comprenant les orifices et dont la première est reliée à une chambre à vide et la seconde à un réservoir (6) contenant le produit à transférer, **caractérisé en ce que** le corps (1) est en contact étanche par rapport à la surface (10) comprenant les orifices des cavités et que la première fente (2) soit espacée de façon étanche à la fois de l'extérieur du dispositif et de la deuxième fente (5) d'une distance, mesurée parallèlement au déplacement du dispositif, supérieure à la dimension du plus grand orifice à remplir et que lors du mouvement relatif du corps (1) par rapport aux cavités, la fente reliée au vide soit chronologiquement la première en contact avec les orifices des cavités puis successivement la deuxième fente , de sorte que le vide préalablement réalisé dans les cavités génère une aspiration de produit lors du contact avec la fente de distribution (5), jusqu'à ce que la pression dans la cavité soit égale à celle régnant dans le réservoir.

5. Procédé de remplissage de cavités borgnes par un produit visqueux selon la revendication 4, **caractérisé en ce qu'**un masque intermédiaire (13) est interposé entre le dispositif et le substrat.

6. Procédé de remplissage de cavités borgnes par un produit visqueux selon la revendication 4, **caractérisé en ce que** l'ajustement de la dépression au niveau de la première fente (2) ou (18), conditionne la quantité de produit qui est aspiré dans la cavité de sorte à faire des bouchages ou des remplissages partiels et contrôlés de cavités.

7. Procédé de remplissage de cavités borgnes par un produit visqueux selon les revendications 4 à 6, **caractérisé en ce qu'**il est adaptable sur une machine à sérigraphier (26) en lieu et place de la racle.

8. Utilisation du procédé selon les revendications 4 à 7 pour le remplissage de cavités borgnes par un produit visqueux, **caractérisée en ce qu'**elle donne la possibilité de remplir collectivement des tubes (23) identiques ou différents.

9. Utilisation du procédé selon les revendications 4 à 7 pour le remplissage de trous métallisés d'un circuit imprimé avec une résine isolante durcissable et usinable. Les dits trous sont préalablement rendus borgnes par un moyen quelconque durant le temps de remplissage. Il est ensuite pratiqué un nouveau perçage dans la résine isolante dont le diamètre est inférieur au premier trou et ce nouveau trou est métallisé en connexion avec les faces supérieures et/ou inférieures. Ainsi, il est rendu possible de réaliser des trous métallisés concentriques multicouches. L'opération peut être répétée pour un nombre de couches supérieur à 2, si ceci est souhaité.

10. Utilisation du procédé selon les revendications 4 à 7 pour l'encapsulage de puces électroniques (29) sur un substrat par un matériau isolant et durcissable **caractérisé en ce qu'**il permet de remplir un moule (28) dont les dépouilles sont négatives au travers d'un orifice (30).

## Patentansprüche

1. Vorrichtung zum kollektiven Füllen von Blindkavitäten mit einem viskosen Produkt (7), umfassend einen in einer Translation über die die Öffnungen umfassende Oberfläche bewegbaren und mindestens zwei Spalte aufweisenden Körper (1), von denen derjenige, welcher bei der Bewegung den Öffnungen als erstes begegnet, mit einer Vakuumkammer (3) verbunden ist und derjenige, welcher den Öffnungen als zweites begegnet, mit einem das zu transferierende Produkt (7) enthaltenden Reservoir (6) verbunden ist,
**dadurch gekennzeichnet,**
**dass** der Körper (1) in einem abgedichteten Kontakt in Bezug auf die die Öffnungen der Kavitäten enthaltenden Oberfläche steht, und dass der erste Spalt (2) in abgedichteter Weise zugleich von dem Äußeren der Vorrichtung und von dem zweiten Spalt (5) eine parallel zur Verschiebung der Vorrichtung gemessene Distanz beabstandet ist, welche größer als die Abmessung der größten Öffnung ist.

2. Vorrichtung zum Füllen von Blindkavitäten mit einem viskosen Produkt gemäß Anspruch 1,
**dadurch gekennzeichnet,**
**dass** ein zu dem ersten Spalt (2) identischer und symmetrisch in Bezug auf den zweiten Spalt (5) angeordneter dritter Spalt (18) es der Vorrichtung erlaubt, in den zwei Richtungen in alternativer Weise zu funktionieren.

3. Vorrichtung zum kollektiven Füllen von Blindkavitäten mit einem viskosen Produkt gemäß den Ansprüchen 1 und 2,
**dadurch gekennzeichnet,**
**dass** der untere Teil des Körpers (1) deformierbar ist, um Unregelmäßigkeiten der Oberfläche (10) zu gestatten.

4. Verfahren zum kollektiven Füllen von Blindkavitäten (11) mit einem viskosen Produkt (7), wofür ein Körper (1), welcher mindestens zwei Spalte aufweist, von denen der Erste mit einer Vakuumkammer und der Zweite mit einem das zu transferierende Produkt enthaltenden Reservoir (6) verbunden ist, über die die Öffnungen enthaltende Oberfläche verschoben wird,
**dadurch gekennzeichnet,**
**dass** der Körper (1) in einem abgedichteten Kontakt in Bezug auf die die Öffnungen der Kavitäten enthaltenden Oberfläche (10) steht, und dass der erste Spalt (2) in abgedichteter Weise zugleich von dem Äußeren der Vorrichtung und von dem zweiten Spalt (5) eine parallel zu der Verschiebung der Vorrichtung gemessene Distanz beabstandet ist, welche größer als die Abmessung der größten zu füllenden Öffnung ist, und dass bei der relativen Bewegung des Körpers (1) in Bezug auf die Kavitäten der mit dem Vakuum verbundene Spalt chronologisch derart der in Kontakt mit den Öffnungen der Kavitäten stehende erste Spalt und dann danach der zweite Spalt ist, dass das vorher in den Kavitäten erzeugte Vakuum ein Einsaugen des Produktes bei Kontakt mit dem Verteilungsspalt (5) erzeugt, bis der Druck in der Kavität gleich dem in dem Reservoir herrschenden Druck ist.

5. Verfahren zum Füllen von Blindkavitäten mit einem viskosen Produkt gemäß Anspruch 4,
**dadurch gekennzeichnet,**
**dass** eine Zwischenmaske (13) zwischen der Vorrichtung und dem Substrat angeordnet ist.

6. Verfahren zum Füllen von Blindkavitäten mit einem viskosen Produkt gemäß Anspruch 4,
**dadurch gekennzeichnet,**
**dass** die Einstellung des Unterdrucks beim Niveau des ersten Spalts (2) oder (18) die Menge des Produkts, welche in die Kavität eingesaugt wird, derart bedingt, dass partielle und kontrollierte Zuschüttungen oder Füllungen der Kavitäten bewerkstelligt werden.

7. Verfahren zum Füllen von Blindkavitäten mit einem viskosen Produkt gemäß den Ansprüchen 4 bis 6,
**dadurch gekennzeichnet,**
**dass** es anstelle des Abstreifers auf eine Siebdruckmaschine (26) anwendbar ist.

8. Benutzung des Verfahrens gemäß den Ansprüchen 4 bis 7 zum Füllen von Blindkavitäten mit einem viskosen Produkt,
**dadurch gekennzeichnet,**
**dass** sie es ermöglicht, gemeinsam gleiche oder verschiedene Röhren (23) zu füllen.

9. Benutzung des Verfahrens gemäß den Ansprüchen 4 bis 7 zum Füllen von metallisierten Löchern einer gedruckten Schaltung mit einem härtbaren und maschinell verarbeitbaren isolierenden Harz. Die besagten Löcher werden vorher mit irgendeinem Mittel während der Füllzeit blind gemacht. Es wird anschließend eine neue Bohrung in dem isolierenden Harz ausgeführt, deren Durchmesser geringer ist als der des ersten Lochs, und dieses neue Loch wird in Verbindung mit den oberen und/oder unteren Flächen metallisiert. Somit wird ermöglicht, konzentrische mehrfachbeschichtete metallisierte Löcher zu realisieren. Der Arbeitsvorgang kann für eine Anzahl von Schichten größer als 2 wiederholt werden, wenn dies gewünscht ist.

10. Benutzung des Verfahrens gemäß den Ansprüchen 4 bis 7 zur Einkapselung von elektronischen Chips (29) auf einem Substrat mit einem isolierenden und härtbaren Material,
**dadurch gekennzeichnet,**
**dass** es erlaubt, eine Form (28) zu füllen, deren Formschrägen negativ quer zu einer Öffnung (30) sind.

## Claims

1. Device for filling multiple blind holes with a viscous product (7) that is composed of a translatory mobile body (1) on the surface containing the openings, said body containing at least two slots, the first slot exposed to the openings while moving is connected to a vacuum chamber (3), while the second slot exposed to the openings is connected to a reservoir (6) containing the product (7) to be transferred, **characterized by** the fact that said body (1) is in airtight contact with the surface containing the openings of said blind holes and that the first slot (2) is kept airtight from the exterior of the device and from the second slot (5) by a distance, measured parallel to the direction of travel of the device, that is larger than the largest opening.

2. Device for filling blind holes with a viscous product as in claim 1, **characterized in that** a third slot (18) identical to the first (2) and symmetrical to it in relation to the second (5), allows the device to operate in two directions alternately.

3. Device for filling multiple blind holes with a viscous product as in claims 1 and 2, **characterized in that** the lower part of the body (1) being deformable to allow for irregularities in the surface (10).

4. Method for filling multiple blind holes (11) with a viscous product (7), by implementing a body (1) having at least two slots and moved on the surface containing the openings, the first slot is connected to a vacuum chamber, while the second is connected to a reservoir (6) containing the product to be transferred, **characterized in that** the body (1) is in airtight contact with the surface (10) containing the openings of said blind holes and that the first slot (2) is kept airtight from the exterior of the device and from the second slot (5) by a distance, measured parallel to the direction of travel of the device, that is larger than the largest opening to be filled, and when the body (1) moves relatively to the holes, the slot connected to the vacuum is the first to come into contact with the hole openings, followed by the second slot, so that the vacuum generated first in the holes draws in the product when it is exposed to the distribution slot (5) until the pressure within the hole is equal to that in the reservoir.

5. Method for filling blind holes with a viscous product as in claim 4, **characterized by** the fact that an intermediate screen (13) is placed between the device and the substrate.

6. Method for filling blind holes with a viscous product as in claim 4, **characterized by** the fact that adjustment of the pressure in the first slot (2) or (18) determines the amount of product that is drawn into the hole for sealing or partial and controlled filling of the holes.

7. Method for filling blind holes with a viscous product as in claims 4 to 6, **characterized by** the fact that it is adaptable to a screen-printing machine (26) in place of the scraper.

8. Utilization of the method according to claims 4 to 7 for filling blind holes with a viscous product, **characterized by** the fact that it can fill a group of identical or different tubes (23).

9. Utilization of the method according to claims 4 to 7 for filling plated-through holes in a circuit board with a hardenable and machinable insulating resin. Such holes are made blind beforehand by an unspecified means during the filling stage. A new drilling is then made in the insulating resin with a diameter smaller than the first hole, and this new hole is plated in connection with the upper and/or lower surfaces. In this way concentric, multilayered, plated holes can be made. The operation can be repeated for more than 2 layers if desired.

10. Utilization of the method according to claims 4 to 7 to encapsulate microchips (29) on a substrate with an insulating and hardenable material **characterized by** the fact that it allows filling of a mold (28) with sides that are undercut through the opening (30).
